Europäisches Patentamt

European Patent Office

Office européen des brevets

(11) Publication number: **0 096 503**
A2

(12) # EUROPEAN PATENT APPLICATION

(21) Application number: 83302972.1

(22) Date of filing: 24.05.83

(51) Int. Cl.³: **G 02 F 1/01**
**B 41 M 5/24, G 11 B 7/00**

(30) Priority: 25.05.82 US 381687

(43) Date of publication of application:
21.12.83 Bulletin 83/51

(84) Designated Contracting States:
BE DE FR GB NL SE

(71) Applicant: BURROUGHS CORPORATION
Burroughs Place
Detroit, Michigan 48232(US)

(72) Inventor: Shevlin, Craig Martin
5200 Piedmont Drive
Santa Rosa CA 95405(US)

(74) Representative: Kirby, Harold Douglas Benson et al,
G.F. Redfern & Company Marlborough Lodge 14
Farncombe Road
Worthing West Sussex BN11 2BT(GB)

(54) Heat sensitive film shutter.

(57) A heat-sensing arrangement is contemplated, one employing a monitoring laser system. An improved optical film-shutter medium for such systems is described, this being characterized as an ultra-thin layer of absorber material rendered in an island configuration and adapted to be so affected by the contemplated test-level of heat energy as to "agglomerate" and better transmit the monitor laser beam.

FIG.2.

- 1 -

"HEAT-SENSITIVE FILM-SHUTTER"

The present radiant invention relates to novel material for detecting applied heat energy, and more particularly to such a medium adapted as a film for detecting heat levels.

INTRODUCTION, BACKGROUND

This disclosure relates to optical media and associated techniques and apparatus which are adapted to detect a prescribed level of heat or prescribed radiation energy, especially with low power laser equipment.

As workers know, success in designing and operating such a system depends greatly on the sensing medium. Workers in the art would be pleased to find a simple inexpensive film-medium which could function as a light-shutter to pass or block a monitor beam depending on whether the "film-shutter" had experienced the "test-level" of heat, etc. or not. This invention teaches a practical film shutter for this purpose, one adapted for long service life and for use with available simple low-cost low power laser monitoring equipment.

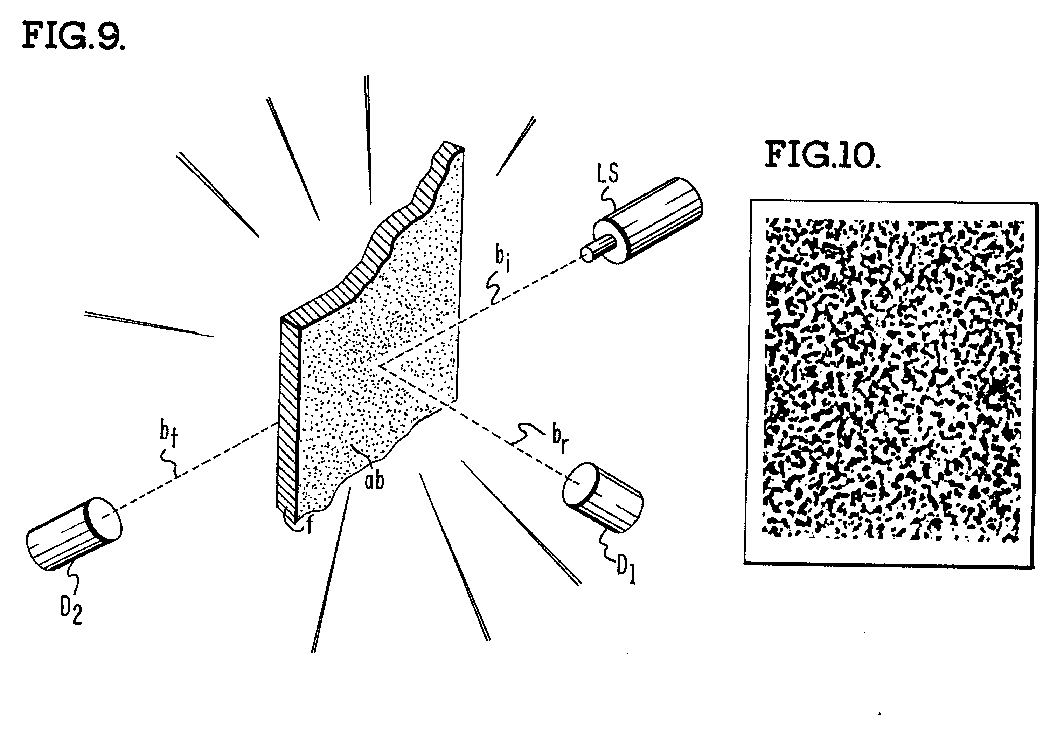

This shutter and various applications will be detailed below (e.g., see FIG. 9 and related description) -- but first a related optical recording medium and its associated applications is described.

--Recording media for radiation beams, generally:

Requirements for such ODD media are stringent; e.g., involving high bit density and cost-effective information storage at satisfactory write/read rates; preferably using low-power lasers. (Workers recognize the simplicity, speed and power of such laser implementation, where one need only modulate and deflect a laser beam for read/write operations).

In related applications (e.g., video disk recording) workers have used lasers and, for certain aspects thereof, have suggested media using a metal film as an "information layer" -- this layer to be softened, melted or vaporized (e.g., thermally-ablated) by a write-laser-beam so as to form a "void" (a pit, hole, bubble, etc., or other deformation) in the layer as the "bit". Such a film may be coated on the surface of a rotating disk.

Some workers have felt that such laser recording would be promising for computer records of various kinds; e.g., the mentioned ODD media. They have predicted that practical systems await archival media which is responsive to low-power laser writing and that this in turn depends on whether one can find such an information layer (material) able to be melted (or vaporized, etc.) at current practical low-power levels. This may also depend on the radiation efficiency of the associated system.

Thus, workers have for some time been looking for such laser recording materials which exhibit high "thermal efficiency" (a measure of how much of the heat generated at the recording site remains sufficiently localized to allow "pit" formation). For this they have considered recording materials with a low melting point and low thermal diffusivity (tellurium, lead, bismuth and indium are examples). The low melting point presumably facilitates a write-pulse of minimum energy -- thus minimizing system cost or increasing bandwidth.

And, since workers feel one must use a low-power laser for such recording (e.g., to enhance the operating life of a laser and minimize its cost and size), it has seemed even more desirable that the metal chosen for such an information (absorber) film have an "outstandingly-low" melting point ("adequately-high sensitivity") so that the desired "bit-void" may be formed with minimal laser power.

--Te absorber films:

Now, many workers have contemplated using tellurium (Te) absorber films for this, or related, laser-recording. There are several reasons. Tellurium has an attractively low (bulk-) melting point (about 450°C), conducts heat poorly and appears able to provide good sensitivity and S/N ratio; also, it is relatively convenient to deposit as a thin film. Bismuth is also commonly suggested for similar reasons. And related alloys (e.g., as Te-Ge, Te-As-Se and Bi-Se) have been suggested as of interest.

Tellurium has been thought to exhibit a low write-threshold (energy) -- e.g., when compared with Aluminum -- as well as having a relatively low thermal diffusivity -- e.g., see U.S. 4,222,071 to Bell, et al; also see "Review of Optical Storage Media" by Zech, SPIE Vol. 177, Optical Information Storage, 1979, page 56 et sequ.; and also see "Optical Recording Media Review" by Bartolini, page 2 et sequ. of 1977 SPIE Vol. 123, "Optical Storage Materials and Methods".

For instance, this Bartolini article discusses such absorber films ("Ablative Thin Films") along with ten other optical recording means -- including "Photopolymers", that is organic compounds known to undergo photochemical changes which involve a shift in refractive index. The Zech article discusses absorber films arranged and used so that with laser-writing a "pit" is developed in the absorber layer, this information being detected according to differential reflectivity (similarly for Bell patent).

For such known "deformational recording", it appears that the thermal energy delivered by a high intensity radiation beam ("Write-Beam" of a Laser) is such that the "write-site" will soften, melt or ablate, in at least part of the beam cross-section. Many believe that surface tension then causes a "transverse cavitation" (see article by Zech cited above), leading in turn to the formation of a "pit" or hole, usually slightly elliptical. (See "Melting Holes in Metal Films for Real-Time, High Density Data Storage" by Cochran and Ferrier, SPIE Proceedings, August 1977, pages 17-31).

--Absorber films:

As one feature hereof, I have discovered that a related kind of laser-recording can be done at temperatures well-below the melting point of such an "absorber" (i.e., without heating the bit site to its "bulk-melting-point"). And, as a result I have also discovered that materials like gold, having a relatively high melting point and rather high thermal conductivity -- characteristics heretofore shunned by workers for the instant purposes -- can yield a surprisingly good absorber film; one comparable in sensitivity to "hitherto-preferred" absorbers like Tellurium.

Of course, some have vaguely speculated that "high melting point" materials like Titanium and Gold (also platinum, rhodium, nickel, chromium, manganese and vanadium -- e.g., cf. U.S. 4,285,056 to Bell or IBM, TD Bulletin, March '71, page 3001) might be suitable for such "deformation" absorber layers. However, such speculations have paid no heed to the practical problem of "sensitivity" or to how a lower power laser can record on them as mentioned above. Or they have ignored the associated problem of high conductivity (where heat is readily conducted away from the recording site, write-energy is wasted, and sensitivity degraded -- note a metal like gold has a high thermal conductivity, whereas Ti and Te do not).

Observers have heretofore generally acknowledged that "high-melting-point" metals are quite unlikely as absorber candidates (e.g., as expressed in cited U.S. 4,222,071 where the "low-melting-point" and poor conductivity of Te was heartily endorsed as yielding superior sensitivity and enabling one to record with a low-power laser. Thus, metals such as Au, which are the REVERSE; i.e., good heat conductors with high melting point, should, in theory, be the worst "absorbers"). Yet, the present invention teaches that just such metals as gold can be so used and can function at least as well as known absorbers -- e.g., having a sensitivity somewhat equivalent to Te, along with much superior archival life.

This invention, further, teaches that such absorber films -- contrary to what is taught in the art -- evidently need not heat the bit site to the classic bulk metal melting point for recording.

--Extended archival life:

A major attraction of optical data storage technology is the increased storage capacity it promises; e.g., the order of 100 X that of magnetic tape. An optical data disk as here contemplated will be assumed to store("non-erasable") information thereon for an extended archival life on the order of 10 years or more. Such extended life is a goal as yet unattained in the art, though workers would dearly love to do so. The present invention promises media exhibiting such archival life, being especially adapted for optical mass memory and like applications.

By contrast, commonly-suggested absorber metals like bismuth and tellurium are known to oxidize all too quickly and to otherwise readily degrade in the typical user environment; hence, they are poor candidates for such archival records (e.g., see cited article by Ash, et al. 1981; and Zech article; also demonstrated by Example I below). Workers acknowledge that Tellurium has particularly poor archival stability -- i.e., its read-out signal quickly degrades with time. This degradation is accelerated in a high humidity environment; and is typically characterized by a rapid increase in overall optical transmission (presumably caused by a general oxidation of the metal), as well as by severe attack on selected bit sites, beginning at "defect sites" in the metal film. And bismuth is similar.

Extended archival stability is addressed by this invention which teaches the analogous use of absorber films of gold, etc. -- materials which are quite archival and are stable for extended use as computer information storage media, especially as for such optical data disk records for (as in Table I) computers.

Thus, as a feature of novelty, I contemplate the use of such materials for records exhibiting extended archival life, i.e., being extremely resistant to oxidation or like environmental degradation, during typical EDP storage and use (thus, no "loss" of recorded information occurring over extended, storage life, with reflectivity remaining stable enough to "read") -- something no practical storage medium or associated system can yet provide; especially where "good" sensitivity is also required. The invention teaches just this step forward.

The novel recording media and associated deposition techniques taught herein will be generally assumed as meeting the foregoing criteria; and, where possible, as also meeting one or more of the "target performance criteria" presented in Table I below. (See also "Optical Properties of Tellurium Films Used for Data Recording" by Ash and Allen, SPIE Proceedings, Vol. 222, 1980; "Design and Production of Tellurium Optical Data Disks" by Rancourt, SPIE Proceedings, #299, 1981).

TABLE I (Target Criteria for Media)

1.      "High" Sensitivity:

--allow recording by low-power laser means. "Sensitivity" will be understood as minimum laser power needed for bit formation (change in spot reflectivity, akin to that resulting from formation of a hole, or other void or like change in medium, giving adequate read-out at contemplated recording rate).

With the invention, one may typically "write" with the order of 5-15 mW laser power for approximately 40-60 n.sec.; (pulse duration), -- yet not degraded by read-out (i.e., on repeated playback).

1-A.    High S/N: (adequate read-out)
Signal to noise ratio (for adequate read-out) on the order of about 30-40 dB Min. peak signal to RMS noise.

2.      "Archival Stability": (10 + years life):
Able to be used or stored in "normal computer environment" without dropping below min. read-out for about 10-15 years (maintaining min. S/N).

3.      "Computer records":
Assume capability to operate with present day high speed digital computers -- e.g., with at least the same capabilities as today's magnetic disk storage equipment (e.g., bit density of about $10^6$ bits/$cm^2$ or better) --Raw Bit-Error Rate" less than $10^{-6}$.

4.      "Deposit-able" -- suitable film(s) can be deposited on "commercial scale" and give repeatable, controlled characteristics.

5.      Overcoat-ability: absorber film can be super-coated (e.g., up to a few mils) to mechanically protect it and defocus "surface dirt" without sacrificing above features,e.g., still give adequate read-out (preferably overcoat can also impede heat and contaminant-gases, etc. from absorber film).

Thus, it is an object hereof to provide the foregoing, and other related, features and advantages. A more particular object is to do so, teaching the deposition of gold and like absorber (information) films in "island" or like discontinuous form. Another object is to teach such films exhibiting good sensitivity, adequate for low-power lasers; as well as extended archival life. A further object is to teach preparation of such records which are suitable for recording without need to 'melt' the information layer; i.e., developing "altered reflectivity" bits (pits) while keeping the site well below its bulk melting temperature.

BRIEF DESCRIPTION OF THE DRAWINGS

These and other features and advantages of the present invention will be appreciated by workers as they become better understood by reference to the following detailed description of the present preferred embodiments, these being considered in conjunction with the accompanying drawings, wherein like reference symbols denote like elements:

FIG. 1 provides a cross-sectional view of an idealized portion of a prior art recording medium;

FIG. 2 provides a similar view of a novel preferred recording medium embodiment exhibiting a construction in accordance with principles of the present invention;

FIG. 3 is a similar view of a preferred disk record embodiment;

FIG. 4 is a plan idealized view of a certain recorded bit site;

FIG. 5 is a sectional view of another preferred embodiment;

FIG. 6 is a greatly-enlarged plan schematic of a portion of another bit-site written-upon according to the invention;

FIG. 7 is a plot of Reflectance vs $\lambda$ for two embodiments;

FIG. 8 is a plan schematic view, greatly enlarged of a portion of an alternate embodiment;

FIG. 9 is a mechanical schematic of an alternate application of the invention; and

FIGS. 10, 11, 12 and 13 are TE micrographs of various embodiment films.

## DETAILED DESCRIPTION OF THE INVENTION

"Te Example"; Tellurium absorber; ("Control"):

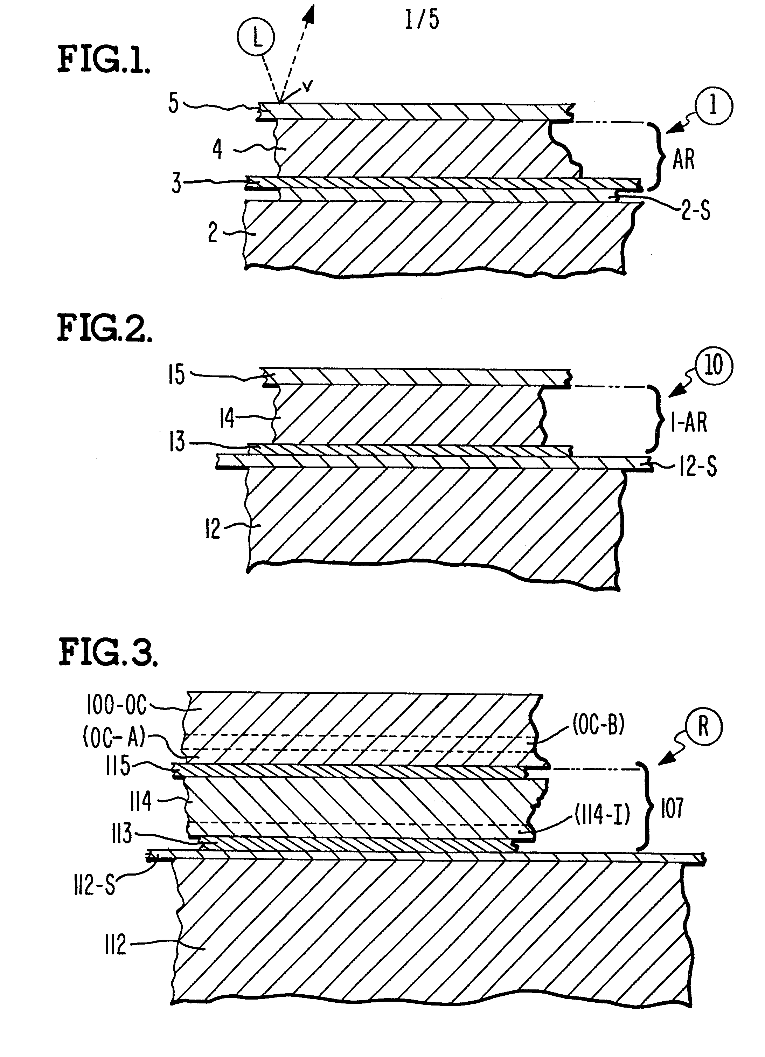

FIG. 1 is a schematic illustration of an idealized cross-sectional view of an optical recording medium 1, understood as fabricated and operated generally along the lines of what is presently taught in the literature for tellurium (e.g., see Ash article). Medium 1 comprises a support 2 on which is provided an "anti-reflective" base AR and, on AR, an information layer ("absorber") 5.

Preferably base AR comprises a "reflector" layer 3, on which a transmissive "spacer" layer 4 is laid. Layers 3 and 4 may be characterized as, respectively, primarily-reflective and primarily transmissive at the contemplated read/write wavelengths. Layers 3, 4, 5 will be understood as providing a multi-layer, low-reflecting (anti-reflection) design over most of the visible spectrum as known in the art (see Ash article).

Preferably, reflector 3 is an opaque layer (e.g., approx. 600 $\overset{\circ}{A}$ found satisfactory) of aluminum or the like, while spacer 4 is transparent fused silica, or a like transparent dielectric, approximately one-quarter wavelength thick. [i.e., N x $\lambda/4$ where N = 1,3,5,etc.].

Support 2 preferably comprises a polished aluminum disk of the type presently used in digital magnetic recording for computer disk drives, coated with an organic smoothing (subbing) layer 2-S adapted to render a satisfactorily-smooth, flat surface for deposition of reflector layer 3.

This will be understood as preferably comprising a 14" disk to be operated at about 1800 (to several thousand) rpm with good surface smoothness (e.g., order of less than 4 micro-inches peak-to-peak).

A radiation (laser) beam of prescribed energy and wavelength may be understood as applied to medium 1 from a laser source L, so as to establish a "pit" or like "deformation" on layer 5 as "writing" takes place (e.g., at site "v" shown in phantom). More particularly, it will be desired to use a 10 mW gaussian beam with diameter of 0.8 μm (i.e., 8000 Å or 1/$\Sigma$) and scanning at 45 m/sec., to form a "pit" with a certain minimum length and width of 0.8 μm (though not necessarily circular or other prescribed shape, -- this requirement is too stringent for conventional means however).

Prior art record 1 in FIG. 1 will be understood as undertaken and described principally to provide a means of comparison and distinction for the invention embodiments in the following examples. And, except as otherwise specified, all materials, methods and devices and apparatus herein will be understood as implemented by known expedients according to present good practice.

Here, the metallic recording film 5 will be understood as deposited on the "transparent" dielectric spacer 4, with both thicknesses selected to yield a known low-reflectivity structure (e.g., in Bartolini article, less than 3% reflectivity obtained with 5 nm Ti on 80 nm $SiO_2$ spacer recording at $\lambda = 488$ nm). Then, where each "pit" (bit) is recorded, this "anti-reflective" background will be disrupted such as to yield "bits" adapted for high-contrast read-back. And, where the recording wavelength is shifted, the spacer thickness is readily altered to give like results. In this "tri-layer" or "Dark Mirror" configuration surface reflectance (on absorber 5) can be made "zero" or a selected value by adjusting absorber thickness and spacer thickness. (A "tri-layer" being here understood as comprising a transparent spacer with absorber on one face and reflector on the other).

Workers will recognize that in certain cases the reflector film may be eliminated (e.g., in favor of a "dielectric mirror") and that spacer 4 may comprise other materials/structures (e.g., several layers of like material that is also more insulative thermally).

Thus, the coating parameters here will be understood as selected to preferably provide an "anti-reflective" condition for the so-coated disk at the contemplated recording frequency when the write beam is focused on this absorber layer. [Regarding such see: "Anti-Reflection Structures for Optical Recording" by Bell and Spong, Journal of Quantum Electronics, Vol. QE 14, No. 7, July, 1978; and for general prior art, see exemplary articles: "Optical Disk Systems Emerge", IEEE Spectrum by Bartolini, et al, August 1978, page 20; and "Optical Recording Media Review" by Bartolini, SPIE Proceedings, Vol. 123, 1977, page 2; "Optical Storage Materials and Methods", SPIE Proceedings, Vol. 177, Optical Information Storage, 1979, page 56].

Preferably, deposition proceeds by thermal evaporation until the reflectance of layer 5 reaches a predetermined reflectance level.

As workers know, this may be done empirically, or by continually monitoring the reflectance of the absorber film (e.g., on a witness-chip) as layer 5 is deposited (see deposition techniques described by Zech in his cited article) or by like suitable optical techniques for deposition-monitoring; or by other known methods, such as monitoring deposited mass or by electrical properties.

Thus, one may vapor deposit an opaque layer 3 of aluminum onto coated disk 2 (all optical characteristics taken relative to contemplated R/W laser spectrum of 4000-9000 $\overset{o}{A}$). Then, a layer 4 of $SiO_2$ (fused silica or like "transparent" dielectric) is vapor-deposited on layer 5 to a prescribed thickness, this thickness related to $\lambda_0$, the operating wavelength (--here, may be slightly less than either $\frac{1}{4}\lambda_0$ or 3/4 $\lambda_0$). Atop layer 4 is vapor-deposited the absorber film 5 to a thickness which produces the prescribed reflectance (see below).

The reflectivity of the record medium 1 will be understood as modified at each bit-site "v" by the radiation beam from write-laser L, so that, upon detection with a suitable means, the "void areas" v (i.e., "pits") may be distinguished as relatively "high reflectance spots" from the low reflectance "non-void" background surrounding them, as known in the art.

For instance, U.S. 4,285,056 to Bell describes a like medium where information is recorded as "openings" in both the absorber and transmissive spacer layers, with the lengths of the openings and of the unexposed intervening areas being varied along a specific information track to convey frequency information. This patent also calls-out various materials (e.g., among them titanium, rhodium, platinum, gold, nickel, chromium, manganese and vanadium) to be deposited using standard evaporation or electron beam evaporation techniques. By comparison, U.S. 4,183,094 to Keezer et al. calls for laser recording on Te-Ge-Se-S materials to yield "interference changes" without creating such pits.

However, Bell diverges from what is contemplated here in requiring that his spacer layer be heated by the write beam -- heated sufficiently to either be itself ablated-away (i.e., to otherwise develop a void within itself) or else to be decomposed or sublimed and then out-gas sufficient to cause a "bubble" lifting the super layer (e.g., of gold) -- in the present case, essentially no beam energy is to be absorbed by the analogous spacer layer.

Tellurium is a "low melting point/poor conductivity" metal commonly preferred by workers because it is felt to exhibit superior sensitivity, thus minimizing required (threshold) laser write-power.

For instance, this feeling is expressed in U.S. 4,222,071 to Bell and Bartolini, where similar tellurium films were characterized as requiring laser-power on the order of 15+ mW for writing thereon (to achieve adequate read-out, about 20% optical efficiency being assumed -- the goal being to permit recovery of recorded video signals with about 40-50 dB S/N, or "broadcast quality" read-back).

[They also specified a solid state Ga-AL-As injection laser, apparently applying a continuous beam about one (1) micron in diameter at the record surface, which is thewhile kept moving past this beam].

U.S. 4,222,071 stresses that the absorber must be a "low melting point metal" like Te (as well as being deposited in a "continuous film", and not as "microscopic agglomerates"; i.e., evidently not as "islands" or in "insular" form as below).

--Preparation of absorber layer 5; (FIG. 1):

Absorber layer 5 preferably comprises a relatively thin layer of tellurium which is vapor deposited (thermally evaporated) onto spacer layer 4 (on a relatively flat --$\sim\leq 1/20\ \lambda$ -- record surface thereof. The Te is so evaporated in a high vacuum preferably using a large batch coating chamber with corresponding large coating distances and "double-rotation" of substrate, etc. to better ensure uniformity -- e.g., using a refractory metal boat for a source [1.2 m box type coating chamber used in Ash article]. All dust and stains on parts should be reduced to a strict minimum, using the most rigorous "Clean Room" techniques.

Substrate 2 comprises a flat, aluminum plate polished to desirable flatness and coated with "subbing" 2-S to appropriate flatness to accommodate deposition of thin reflector layer 3 (high reflectivity over at least the "working portion" of the contemplated radiation spectrum). About 600-900 $\overset{o}{A}$ of aluminum (prefer about 600 $\overset{o}{A}$, vapor-deposited) has been found satisfactory. Since aluminum is not a perfect reflector, workers will recognize that in some cases one will substitute a "multi-layer dielectric stack" or the like.

The spacer 4 is likewise deposited atop reflector 3. Spacer 4 is a dielectric material which is relatively transparent to the "working portion" of the laser spectrum. About 1583 $\overset{o}{A}$ of vapor-deposited $SiO_2$ (silicon dioxide) has been found satisfactory for the subject purposes (e.g., for write/read at $\lambda = 6328\ \overset{o}{A}$).

The tellurium absorber layer 5 will be understood as highly absorptive of the contemplated recording laser spectrum (e.g., typically 25% absorptive; 30% reflective; with about 45% of the beam energy transmitted (for tri-layer cancellation, must transmit more than reflect).

The thickness of absorptive layer 5 depends on that of spacer 4. Where transmitted light should be reduced, one may wish to increase spacer thickness (in N x λ/4 periods -- also reducing heat-loss possibly).

Workers would view the Te absorber 5, with its low melting point and a relatively short thermal diffusion length (poor conductivity) as a good, "high sensitivity" material which helps conserve incident laser energy. When a write beam from laser source L falls upon site "v" of layer 5, a small portion of its energy will be reflected, a small portion absorbed and a large portion transmitted -- the transmitted portion being reflected back by layer 3 to be (principally) absorbed in layer 5. Hence both incident and reflected energy will heat film 5, minimizing transmission losses (note: deposition of 5 yielded a "tri-layer"). Variations in absorber thickness or uniformity should be scrupulously avoided since this can reduce the write-energy coupled into the absorbing film and degrade sensitivity.

--Results:

For present purposes, "Sensitivity" will be understood as characterizing the write-energy $E_w$ necessary to change reflectivity (or a like read-out characteristic) sufficient to give the specified minimum read-out.

The intensity and time exposure of the focused Write-Beam will be understood as sufficient to so elevate the temperature of absorber layer 5 as to cause the indicated change in reflectivity (at v sites) giving the desired read-out quality, etc. (e.g., so that adequate contrast, S/N ratio) may be realized, as understood by workers in the art, -- cf. an exemplary S/N ratio of 40-50 dB (peak-to-peak signal vs. RMS noise) for a bandwidth of about 15 MHz.

Here, test recording is to be performed with a gas (He-Ne) laser beam operating at 6328 Å, with recording exposure from 30-470 n.sec. (usually 10 mW, 40 n.sec. or about 400 p.J. -- this intended to yield minimum adequate read-out, or about 40 + dB S/N, when read at lower power; e.g., viz: 150-500 pJ/cm$^2$ (pJ = $10^{-12}$ watt-sec. or Joules), with the same or similar laser equipment. Note: for this contemplated setup, assume laser focused on bit site of $\sim$½-1 micron diameter, (i.e., 5000-10000 Å) and thus a write-pulse about 40 n.sec. long [60 n.sec. from rise to fall -- this also accommodating disk rpm of 1800 and associated galvo-mirror focus characteristics].

The subject record 1 is so-recorded upon. It is found (relating to comparable situations in the literature, etc.) that relatively low-power laser pulses can melt the Te film sufficient to yield the well-known "pits" or "craters" and give good read-out (e.g., bit reflectance of $\sim$50% vs. background of 1-3% at $\lambda$ = 6328 Å) -- however with quite a bit of "noise" too.

Such "bit-pits" will be seen to constitute actual voids (e.g., see photos in Ash article where 2-10 mW, 100 n.sec. laser pulse recorded such "craters" in like Te films -- there, it was assumed that a 250 Å film of Te used in the reflective mode produced 57% reflectance, 6% transmittance, 37% absorptance at 4500 Å).

However, despite the fact that such Te films are deposited as a continuous layer, the formation of the "bit-pits" (v) is described in the literature as accompanied by a surrounding rim -- and it is thought that this rim is responsible for (much of the mentioned "noise").

Evidently one needs a certain MIN. Write-Energy $E_w$ within a certain minimum rise-time (e.g., with this laser etc. about 10 mW within 40 n.sec.) to render adequate "holes" (e.g., higher power delivered too slowly can allow heat-at absorber to leak away; thus no "bit" is written).

Such "holes" or "pits" are suggested by the hole-site at "v" in FIG. 1. At least some of the absorber material 5 is then evidently softened and displaced at that bit-site, sufficient to reduce its thickness there and so give increased reflectivity (at least that is what the art conventionally teaches, e.g., see Ash article and cited U.S. 4,222,071).

Such a spot may be read-out with means known in the art; e.g., with a similar laser at low power (e.g., above described laser at 3 mW), the increase in reflected energy received (at a suitable photo-detector) is observed to yield an output signal representing the recorded bits, these being readily distinguishable from background -- this read-energy being insufficient to "erase" or disturb the so-recorded bits, of course. [Note: read-out at a frequency $f_R$, where "pit-depth" introduces a phase change vs. light reflected at surface of Te such as to maximize contrast therewith].

--Archival stability:

I found that the archival stability of this "Te record" was extremely poor, as the literature has noted (e.g., see Ash article re oxidation, etc.). For instance, under known temperature-humidity cycling, record 1 will be found (using no overcoat on layer 5) to gain 50% of its reflectivity in about 2-3 weeks, evidently mostly via oxidation, etc. (cf. a "hole" should have "high" relative reflectance -- oxide increases "background reflectance" between holes -- washing-out necessary S/N). The Te film of Example I will be found characterized by a rapid increase in overall optical transmission after such "aging". This is presumably caused by a general oxidation of the metal as well as severe selected site-attack beginning at "defect sites" in the metal film, (cf. analogous test per MIL SPEC #810-B).

This is grossly inadequate for the mentioned "archival memory" requirements (about 10 years exposure to normal computer operating/storage conditions; see Table I).

EMBODIMENT EXAMPLES

The following Examples are given by way of teaching some exemplary uses and advantages of "low temperature" absorbers in island-film form according to the invention. Advantages and features thereof will be better appreciated by comparing them with the "Te Example" described above.

--Example I; absorber of gold material; FIG. 2:

The operations, materials, methods and structure of the "Te Example" (FIG. 1) described above are repeated here, except as otherwise specified, in a novel record 10 (FIG. 2) having a "gold-absorber" film 15 replacing the tellurium film 5.

Record 10 will be understood as comprising a support 12 on which an "anti-reflective" base 1-AR is laid (like AR in FIG. 1, preferably comprising a reflective layer 13, with a transmissive spacer layer 14 laid upon 13), with absorber film 15 placed atop substrate 1-AR (spacer 14 thereof).

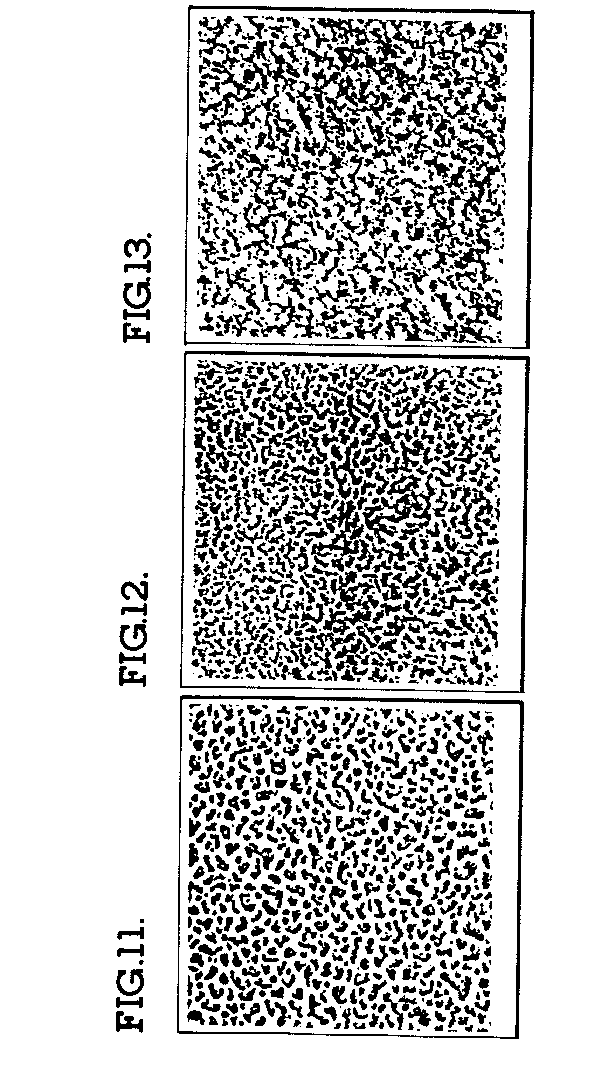

Here, and according to a feature hereof, absorber 15 comprises a film of "gold material" comprising an "island layer" deposited to function as an absorber film (somewhat like the Te film in the "Te Example", e.g. in a somewhat similar process and by similar means). Here, very close attention is paid, during deposition, to controlling absorber thickness so that it yields a prescribed minimal "Dark Mirror" reflectance $R_m$ (e.g., here 10% was chosen) as further described below. Importantly, film 15 is formed to be discontinuous, being formed in an island configuration for optimal results, as shown in FIG. 11 (100,000 x Te micrograph) and as described below.

The underlying spacer layer 14, reflector layer 13 and substrate 12 are (at least functionally) otherwise the same as in "Te Example", and thus will be understood as functioning as a "tri-layer", with absorber 15, as understood in the art (e.g., see cited references).

Thus, gold absorber film 15 is preferably formed by vapor depositing a gold material on the surface of $SiO_2$ spacer 4 until (monitoring the well known "tri-layer" effect) surface-reflectivity of 5 first drops to a preselected value $R_m$ (10% reflectance here), taking care to render the "insular" configuration. Reflectance $R_m$ may, conveniently, be set at any desired value consistant with adequate "writing" and read-out. Here, about 10% was arbitrarily selected (minimum for proper focusing, etc. of this laser) and , somewhat surprising to discover, "writing" with the mentioned laser beam (as in Te Ex.) shifted reflectance enough to give adequate read-out in the described manner (i.e., a "written spot may be seen to exhibit 25-55% reflectance, yielding the desired S/N in the 25-40 dB range -- in some cases a 30-50% increase is satisfactory). Workers will appreciate how other "minimim reflectance" values may be chosen for the "virgin" absorber film.

--Preparation of absorber layer 15; (FIG. 2):

Absorber layer 15 thus comprises an extremely thin "island-deposit" of gold which is vapor-deposited (thermally evaporated) onto spacer layer 14 (i.e., on a relatively flat; e.g., 0.5 λ record-surface thereof). Somewhat unexpectedly I found that if gold is so deposited on this "tri-layer coating" only until such a "minimum reflectance" $R_m$ as 10%, the "islands" are formed such that, when subjected to the described laser write-beam (6338 Å, 10 mW for 40 n.sec. etc.), reflectance -- quite desirably, yet wholly unexpectedly! -- changes significantly: quite enough for adequate read-out (e.g.. going from about 10% to about 25-55% -- see below for detailed discussion of Results).

The absorber film 15 is thus preferably vacuum deposited on spacer layer 14 using present preferred techniques (e.g., "pure" gold has been so deposited in large vacuum chamber at $\sim 10^{-6} - 10^{-7}$ Torr., from a molybdenum boat which was resistance-heated -- deposition rate was about 5-10 Å/sec.).

Preferably, the silica layer 14 was, itself, likewise vapor-deposited before receiving the gold film 15. All substrates were cleaned according to present good practice for optical thin films.

It is important that this deposition (by thermal evaporation) proceeds only until the reflectance of film 15 first attains the predetermined "minimum-reflectance level"($R_m$)yielding the desired "islands" -- otherwise the subject results may not occur.

As workers know, this may be done empirically, or by continually monitoring the surface-reflectance of a witness-chip while absorber film 15 is deposited until satisfactory "islands" appear (and see deposition techniques described by Zech in his cited article, or by other known methods, such as monitoring deposited mass or electrical properties during deposition).

--Results:

The results are most surprising, especially in light of expected properties and as compared with conventional media like the Te absorber prepared as above-described in the "Te Example". That is, record 10 was recorded-upon, read-out and evaluated, with its sensitivity, etc., measured, as in the "Te Example" (e.g., using an He-Ne laser system of the type mentioned). The so-written bit sites appear to be "agglomerate-holes" (where absorber has been made to "agglomerate" and where absorber material may also be caused to migrate toward the hole-periphery, or beyond) -- this across a hole-diameter comparable to that of the read-beam (e.g., $\frac{1}{4} - 3/4$ thereof); to exhibit a like increase in reflectance and higher output signal.

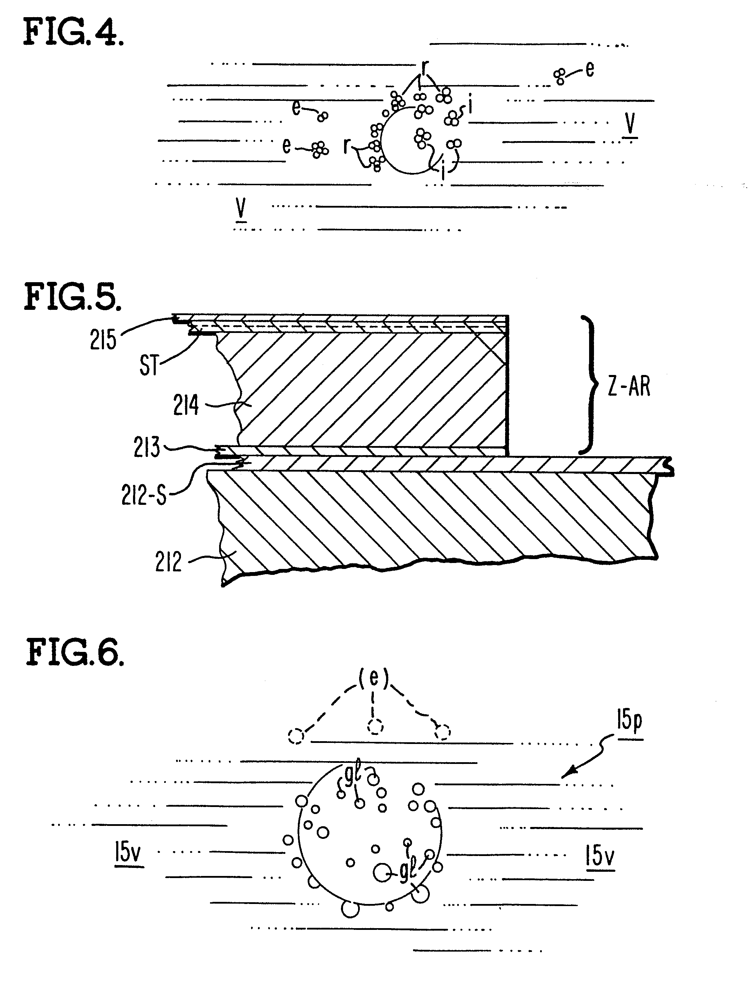

FIG. 6 is an artistic rendering showing such an "agglomerate-hole" (or "quasi-pit") as seen in photomicrographs of such records. Here an "agglomerate-hole" $15_p$ will be understood as a somewhat-circular written-spot, or physical-optical discontinuity in the virgin unwritten absorber film $15_v$. Spot $15_p$ will be on the order of laser beam-diameter (e.g., 40-120% thereof) and may include a "rim" or partial-rim about its periphery, Within the rim, relatively less absorber material is usually present; what there is will be seen as consolidated into absorber-globs gL, most of which are relatively large (e.g., usually fewer, many being larger than the tiny "islands" of virgin film $15_v$ and FIG. 11, (and lie relatively farther apart). In effect, spots $15_p$ will be understood as constituting an "optical void" or discontinuity at the selected read-wavelength ( $\lambda_w$ ); whereas the virgin island film $15_v$ appears as a relatively continuous (partial) reflector.

Thus, workers will appreciate how such "agglomerate-holes" $15_p$ can be the functional equivalent of conventional pits like those known with tellurium (see Te Ex. and references cited).

As detailed below, one finds that such an "insular" absorber film can yield a superior record; one giving considerable archival stability, unexpectedly-high sensitivity and high S/N while requiring surprisingly low write-energy, and low write-temperature evidently -- and also apparently having good tolerance to an overcoat. [E.g., where a useful overcoat doesn't degrade operational performance beyond practical usefulness -- as it presently does with Te absorbers, perhaps because these evidently require a relatively massive translation of absorber material -- in contradistinction, workers will be pleasantly surprised to note that the invention can "record", i.e., "open" a bit-hole to pass the Read beam, without necessarily so-translating most or all of the absorber out of the bit-site -- instead the invention can operate by merely "agglomerating", and thus redistributing absorber within the bit-site, with little or no material necessarily moved outside the site, or ablation-ejected therebeyond, etc.]. Details are given below.

--Island form of absorber film:

FIG. 11 is a microscopic plan view (100,000 x TE micrograph) of the original,virgin (i.e., unrecorded-upon) reflecting surface of an Au absorber film like that above-described. It will be evident that this surface appears as a physically discontinuous, or partly discontinuous, "insular" configuration, exhibiting a fairly regular pattern (semi-islands on the $SiO_2$ spacer). For this Ex. I, the islands will be understood as having diameters on the order of a few hundred $\overset{o}{A}$ (e.g., 100-300 $\overset{o}{A}$ typical), separated by intervals of comparable dimension (e.g., 50-200 $\overset{o}{A}$ apart -- vs. laser beam 5000-10,000 $\overset{o}{A}$ wide; cf 6328 $\overset{o}{A}$ wavelength). The virgin film 15 will thus exhibit a certain "% void" range (e.g., a few % to 10% voids).

Now, subjecting a portion of this virgin film to a laser recording beam as described acts to "agglomerate" these "islands", increasing the "percent void" in the site (larger island-spacing) and ejecting some island mass out to the site periphery and beyond, (see ejecta e) forming a (small, not necessarily continuous) "rim" there in some cases -- thus forming an "agglomerate-hole" as in FIG. 6 this process is, here, loosely characterized as "agglomeration".

This "island" configuration was not expected -- yet more surprising were the unusual "recording properties" realized and effects which were quite different from what the properties of "bulk gold" would indicate!

As mentioned above, forming ODD absorber films into an "island" configuration is unmentioned in the literature; moreover this is contrary to present good practice (e.g., as U.S. 4,222,071 makes clear -- see above discussion).

At least some of the first-order factors controlling such island formation are: absorber material, deposition-rate, adhesion; substrate material and condition (e.g., cleaning, roughness, etc.) and temperature; presence of "nucleation layer", presence of vapor-contaminants (vacuum pressure) and like factors
as will be appreciated by workers.  For example, too-cool
a substrate will render a continuous film, but too-hot
will leave no film at all.  In this regard workers may
compare FIGS. 12 and 13 with referenced FIG. 11.  In
FIG. 12, a similar film was prepared (like Ex. I)
except that the silica substrate was coated with a
bismuth oxide layer for nucleation as known in the art.
FIG. 13 was similar, with a chromium nucleation layer
instead.  Compared with FIG, 11, FIG. 12 seemed to
exhibit thinner islands farther apart, while FIG. 13
is a continuous gold film (no islands).

The cited laser apparatus could not "write" at
all on the film of FIG. 13 (at cited power level); while
the film of FIG. 12 wrote like that of FIG. 11 (Ex. I)
except for a bit lower sensitivity.

Workers will appreciate that such "island" pattern
can render certain desired results -- taking into account
such factors as read/write conditions (e.g., write-energy,
beam-width,  $\lambda$, etc.).  Thus. in Ex. I satisfactory "bit
holes" about 4000 to 10,000 $\overset{o}{A}$  diameter were formed with
the specified write-beam, etc. (gave satisfactory S/N, etc.).

One infers that island-diameters which are either
too large or too small will not be satisfactory.  More
particularly, it seems that the virgin size and spacing
of the islands should be such as to accommodate the
described agglomeration, upon recording, with average
island diameter well below anything approaching a
continuous film (i.e., sufficient spacing - percent void
to thermally isolate individual islands); yet large enough (% void low enough) so that absorber film 15 "appears" like a (relatively continuous) "optical reflector" at selected $\lambda$ (R/W lasers). And spacing is presumably large enough so that when a spot is laser-heated (written-upon) it will so "agglomerate" as to form the indicated "agglomerate-hole" causing the film 15 to "optically switch" and exhibit a significant shift in detected reflectance (consistent with required S/N, etc. -- i.e., so the "spot" becomes "relatively transparent" now and appears relatively "open" (transparent) to the optical system concerned, as with a conventional "pit").

Stated otherwise, the write-beam is assumed, here, to so affect the islands in a bit-site as to cause "agglomeration" and the (usually) attendant increase in average island size and spacing (increased % void area). One infers that the initial (virgin) % void will be sufficient to accommodate a prescribed minimal heat loss, radially, yet not so large that initial reflectance ($R_o$) exceeds the desired "near zero" value (required for a "Dark Mirror").

Of course, where a tri-layer is formed with its optical substrate, this will make the absorber-spacer-reflector effectively increase in reflectivity (e.g., as here, from about 10% to about 30%).

In general, one may describe this writing operation as so energizing the absorber film as to, in effect, significantly separate absorber mass at the bit site. Thus where an unwritten spot may exhibit 25% absorption- 45% transmission- 30% reflection, a "so-written" spot may shift these values to about 30% - 10% - 60%, respectively, for the subject write wavelength (tri-layer).

As this "writing" so increases the percent void (area), one infers that the write beam evidently so energizes the islands at the write-spot that their average size increases and their average spacing increases (i.e., they "agglomerate" fewer islands).

--"Island-films" as such:

Now, "thin metallic films in island form" have received some attention in the literature as a general proposition (e.g., see article with this title by Doremus in J. App. Physics: June '66, Vol. 37, #7, pp 2775 et sequ. where gold films were described -- also see "Optical Constants of Aggregated Gold Film" by Truong, et al. in Journal of Optical Society Am. Vol. 66, #2, February 1976, pp 124 et sequ. where such films were formed by evaporating onto hot glass substrates at 300°C, and wherein the authors opine "it is reasonable to assume that the particles themselves have the bulk optical constants"; also see "Structural and Electrical Properties of Discontinuous Gold Films on Glass" by Andersson and Norman in "Vacuum", Vol. 27, #4, 1977, Pergamon Press, Great Britain: studying electrical resistance of such films, indicating that this resistance exceeds that of the bulk gold).

Yet no worker appears to have discovered that there is any advantage to using any such "island films" as an ODD laser recording medium, whether of gold or any other metal. Indeed workers appear to have contemplated only "continuous" absorber films (e.g., see cited U.S. 4,222,071 specifying that the absorber should "not be agglomerated" but should be a "continuous film"; or see IBM-TDB of March '71, pp 3001 teaching a continuous "metal layer such as gold plus an amorphous sub-layer" like amorphous silicon- these layers to be heated to form "a mixture of gold, crystalline silicon and amorphous silicon", etc.).

It was quite accidental and fortuitous that I should so render such a "minimum reflectance" deposition onto a "tri-layer structure" yielding such an "insular" absorber film. Otherwise I would have found no way to provide such ODD records exhibiting satisfactory sensitivity and S/N over a long service life (see below).

Now, as mentioned, such "island" absorber films seem rather strangely and unusually affected by a relatively low-energy "write-pulse" -- so that, without evidently being heated to gold's published melting point, the islands nevertheless spread and re-agglomerate. This is not predicted by the literature!

Many workers have assumed that thin metal films would exhibit the properties of the bulk metal. A few have differed, opining that some properties (none-related to OD disk recording though) may differ. Thus, a worker just could not be sure how such an "island" absorber film would perform in an OD disk context (like that described).

Workers will recognize how surprising it was that such island films could be laser-written so as to generate such "agglomerate holes". One might rather expect that absorber film continuity was needed to so "spread" the softened material at the write-site (e.g., pull-apart the pit site as the cited Zech article postulates: "surface tension" causing a "transverse cavitation", etc.).

--"Archival stability"; (resistance to environmental degradation): was found to be superior to that of the tellurium record in the "Te Example" (and to that of any known tellurium records). For instance, monitoring changes in optical reflectivity under "aging" tests (under a cycled elevated temperature/high humidity environment) will indicate that this Au film is considerably more stable than closely-similar tellurium films. Workers are well aware that gold films will be preferable to meet the stringent "archival" conditions specified here.

--Unexpected "good" sensitivity:

It was a great surprise that such a gold absorber could be reasonably "sensitive" as an absorber. That is, information can be satisfactorily "written" on the gold tri-layer here in the power regime of 5-15 mW/10-100 n.sec. (or 100-1000 p.J.). This is really astonishing -- it is many times the sensitivity level that theory predicted and is really contrary to what the literature teaches one to expect.

That is, compared with known accepted "good absorbers" like Te, gold has such a relatively high (bulk) melting point (about 1063°C vs. about 450°C for Te) and such superior heat conductivity (that of Te is notoriously poor; Au is among the best!), that one would likely expect a gold absorber to exhibit practically no sensitivity at all, and to be far inferior to that of tellurium.

For instance, the literature extols tellurium as having sensitivity which is vastly superior to titanium, and titanium has a high melting point like gold but is as poor a heat conductor as Te -- thus how can gold compare as an absorber? (e.g., Te has the lowest thermal conductivity of any metal, while gold's is about 100 x that of Te -- only Cu and Ag are more conductive).

One reason (see below) may be that a different write-mechanism (for such "bit formation" or "writing") is involved; a related reason may be the "island" form of the gold film as mentioned -- evidently requiring considerably less write-energy than otherwise expected, or than the properties of "bulk gold" would indicate, to alter film reflectivity.

--<u>Low temperature recording</u>:

A major surprise is that the indicated "reflectance transition" occurs at such low (write-) power levels and evidently at such low temperatures (indications are that this occurs at about 300°C, well-below gold's published melting point of 1063°C -- and corroborated by instances where the gold islands are deposited in a polymer and so-recorded upon -- the polymer melting at well below this 1063°C -- see below Ex.s). This can allow workers to turn to a "high-melt" material like gold for the absorber -- i.e., to a material which has superior archival properties, thus alleviating the risk of corrosion and like degradation over extended life.

Of course, the island configuration of the film may account for this apparently-reduced melting point, or it may trigger a write mechanism other than "gross melting" -- one is not yet sure. One theory is that such islands possess such high internal energy that relatively little write beam-energy can trigger their "bursting" and so agglomerating, yet without necessarily "melting them as such".

In any event, workers will certainly welcome the availability of such novel "gold absorbers" because of their evident ease of manufacture, deposition and handling by well-known methods plus their evident superior archival stability and aptness for use in computer disk records (e.g., per Table I); as well as because writing the usual "transitions" on gold brings special unique advantages (--e.g., evidently dispensing with need to heat the absorber bit-site to the classic melt-temperature). Also prized will be the associated reduction in write-energy and record temperature -- all these promising the ability to "laser-write" with much less energy and to write in smaller bit domains. For this reason, it is believed best if the spacer (and any overcoat) be a good thermal insulator with relatively low heat-capacitance -- as further discussed below.

Workers will welcome a system whereby bits are evidently recorded without the intense heat and macroscopic changes inherent in the well-known gross melting (ablating) of the absorber film, as with a Te absorber in the above-described "Te Example" (e.g., without any such massive translation of absorber material).

--Overcoating; effects:

The "Te Example" was also run with a thin overcoating of SiO (100 $\overset{o}{A}$, vapor deposited) on the Te absorber film. This simulated an overcoat, but did not afford a true, functional overcoat of the kind workers would prefer (like several mils of a transparent polymer to permit record handling without scratching, to "defocus" surface dust, grime, etc.; to impede vapor entry, e.g. of water, oxygen; to further conserve writing heat, etc.). But this SiO coat did affect "pit formation", raising required write-energy to about double. (Possibly because it so "squeezed" the Te film at the pit-site as to impede associated displacement of Te material there).

Workers have expected that such "deformation recording" (as with pits in Te, bubbles in other metals, etc.) would be resisted by any "overcoat" (e.g., read-out signal destroyed; sensitivity raised -- the overcoat impeding, if not prohibiting absorber expulsion from the bit-site and barring any "ejecta" of course).

Significantly however, when a gold film like that of Example I was similarly over-coated, little or no such resistance was evident and sensitivity was only slightly degraded -- further evidence that a different type of bit-forming mechanism is at work.

As workers will agree, this reinforces the theory that the instant recording mechanism is quite novel (evidently whatever deformation and/or movement of the island mass accompanies such low-power writing of a "bit", it is better tolerated by an overcoat, i.e., the overcoat presents less resistance to the writing mechanism -- this being consistent with the described "agglomeration"). This amplifies the attractiveness of such absorbers, since tolerance to overcoating is very, very important.

--Absence of "Bulk-Au" properties:

As another feature hereof, and based on the foregoing Example I and others, one would infer that such an "island film" absorber (of gold) is not behaving as would be predicted from its reported "Bulk" (gold) properties (e.g., radial conduction of heat is not likely to be significant). The discovery of such "insular film properties" is significant and is further discussed below.

It would appear that these "agglomerate-holes" (reflectivity-switching) are formed at temperatures well-below the absorber's melting temperature (of gold), that they involve little or no absorber expulsion and that so-writing requires much less write-energy.

In general, workers may expect that such insular absorber films can be used to make OD disks as contemplated (e.g., satisfying all or most of the requirements of Table I).

--Ex II: as I, use Au/Sn:

Ex. I is replicated except that instead of pure gold, the (evaporo-deposited) absorber constitutes gold plus a minor concentration of tin. This is laid-down as a laminate for convenience of deposition: first gold, then tin, then gold (alternatively, one can add other dual layers of tin and gold too). Upon heating, this "laminate" should inter-diffuse to form (mostly) a Au/Sn alloy (mostly gold, so "gold characteristics" should predominate).

This Au/Sn film is substituted as the island-film of Ex. I (for 15 in FIG. 2) and is similarly written-upon. Effects: were qualitatively similar to Ex. I, while exhibiting greatly superior archivability and somewhat inferior sensitivity.

--Adhesion of Au:

It was also observed that the gold islands adhered quite poorly to the cited silica (e.g., easily wiped-off). And, when a clear polymer spacer was substituted (for better thermal isolation, etc.), the gold deposit would not really adhere at all (zero sticking coefficient).

Accordingly, a thin tin "strike" (predeposit in island form -- see Ex III) was conceived and applied as a "nucleation film", and this was rendered on the glass (followed by Au-island deposit). Later a polymer spacer was used. As Ex. III shows the results were highly promising especially with the polymer substrate -- with the adhesion of gold vastly improved, but its island configuration not compromised apparently.

--EX. III - Au on Sn flash/polymer (FIG. 5)

FIG. 5 depicts a replication of Ex. I, (FIG. 2), except that a clear polymer is used as spacer (e.g., Teflon) and a tin-flash ("strike", as adhesion promotor, etc.) is interposed under the pure-gold absorber. Thus, as before, we have a disk 212, a subbing layer 212-S on the disk, then a tri-layer 2-AR consisting of reflector 213, (clear Teflon or like polymer) spacer 214 and absorber 15 (pure Au, in island form, deposited however on Sn layer ST of islands). This was similarly written-upon.

RESULTS: Like Ex. I but much improved gold adhesion, sensitivity, read-out and archivability. That is, the gold (islands) adhered tightly to the substrate (Sn islands on clear polymer spacer). Sensitivity and read-out were much improved accordingly it is believed that this Sn strike not only improves adhesion (to polymer) but also "cooperates" to enhance the optical read-out -- something very surprising.

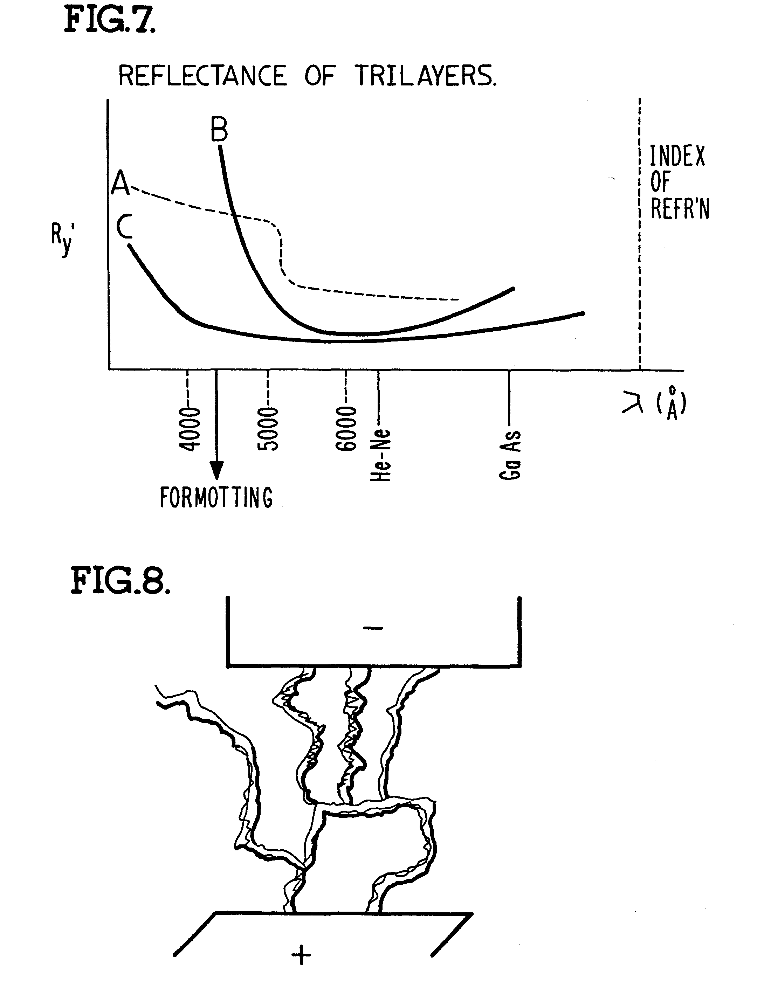

One such surprising optical effect is indicated in FIG. 7, a plot of wavelength vs. reflectance (and index of refraction) of virginal island films. A pure gold island absorber like that of Ex. I might exhibit a shift in refractive index as portrayed by curve A and a reflectance/$\lambda$ characteristic as in curve B. This obviously inhibits operating well above or below the He-Ne laser spectrum (6338 $\overset{o}{A}$ -- e.g., desired formatting of OD disks is not feasible at 4400 $\overset{o}{A}$, etc.; alternate use of Ga-As laser not feasible either). Quite surprisingly, adding the Sn (island-) strike served to "flatten" the absorber's reflectivity curve as indicated at curve C. Workers will appreciate how significant such an increased radiation bandwidth can be.

The archivability of Ex. I (pure Au on $SiO_2$) leaves something to be desired (e.g., in resisting intrusion of water vapor -- perhaps because of its very poor adhesion); whereas this Au/Sn island array was much better.

Of course, the polymer is quite heat-degradable; accordingly the deposition steps (for Sn, then Au) will keep within its temperature limits ($\sim 100°C$) Such gold films should be equal to the "archival" conditions specified here. It is projected that such "gold records" can maintain adequate read-out (30 + dB) for the order of ten (10) years under typical contemplated storage and use conditions.

EX IV: as III with overcoat:

Ex. III is replicated, however adding a clear polymer supercoat on the absorber layer 15 as a protective overcoat.

Results: similar to Ex. III except that sensitivity is degraded a little, though is still passable. Such tolerance to overcoating is a noteworthy property; much desired in the art.

EX V: as III, alloy co-deposited:

Ex. III is replicated except that the tin is co-deposited (in same minor %) with the gold (rather than as a preliminary "strike").

Results: quite similar to Ex III.

Ex. VI: as III, $SiO_2$ on polymer

Ex. III is replicated except that a thin layer of $SiO_2$ is superposed on the polymer spacer 214 (FIG. 5), with the Sn strike deposited on the $SiO_2$ then the gold.

Results: comparable to Ex. III, but sensitivity reduced considerably. It will come as a surprise to workers that such polymer spacers are feasible and that silica is disfavored (silica is widely reported as preferable).

Ex. VII: Au/Sb

Ex. VI is replicated except that antimony replaces the tin (strike on $SiO_2$ −− on polymer).

Results: superior sensitivity to foregoing Examples yet with very inferior archivability and, surprisingly more apt to form intra-hole agglomerates and ring-agglomerates (see FIG. 4, elements i, r respectively) than "ejected" globs (see e, FIG. 4 −− relatively few ejecta e here; e.g., vs. prior Examples) −− FIG. 4 is an idealized showing of a typical "agglomerate-hole" written on such an Au/Sb absorber, the "virgin" island configuration v not shown here.

The latter property (tendency to favor ring and localized agglomerates rather than "ejecta") is striking -- it suggests a susceptibility for controlling the extent of agglomerate migration, and also suggests a hole-forming mechanism likely to be minimally affected by overcoatings (which can be expected to block all "ejecta" e).

Co-depositing such an Au/Sb alloy (same conc.) will give comparable results.

Ex. VIII: Au/Sb/Sn

Ex. III is replicated (Sn strike on polymer), except that an antimony "strike" follows the Sn strike, with gold deposited thereafter.

Results:  quite similar to Ex. VII, with sensitivity a bit worse, archivability a bit better and the same general tendency toward minimal "ejecta" (as in FIG. 4, but a bit more than Ex. VII). Co-depositing the Au-Sn-Sb will yield the same kind of results.

Ex. IX: Pd

Ex. I is replicated except that palladium replaces the gold and a clear polymer spacer is the substrate.

Results:  quite similar to Ex I, and the same general dearth of "ejecta" as in Examples VII and VIII (with greater likelihood of "rim agglomerates").

Ex. X: Pd- Sn

Ex III is replicated, with Pd replacing the gold however (Pd deposited onto Sn strike on polymer).

Results:  vs. Ex. IX, similar except superior archivability.  Otherwise similar to Ex. III (e.g., increased bandwidth, resist vapor intrusion and related dislocation of virginal Au islands, etc.).

### Ex. XI: Au/Pb laminate

Ex II is replicated, except that tin is replaced by lead so the absorber film 15 (FIG. 2) comprises successive island-layers of: gold-lead-gold-lead-gold, each in proper island configuration. When heated, these island layers will readily inter-diffuse (distances so short) to form Au/Pb alloy-islands (Au major constituent, so ignore Pb properties as a first approximation, i.e. thus alloy will exhibit "gold characteristics" predominantly).

While film 15 is so deposited as a "laminate" for testing convenience, other methods will occur to workers.

[Note: this "laminar" form of alloy is selected only for convenience of preparation and investigation; however, once all alloy constraints are settled-upon and optimized, workers will likely prefer to deposit by "co-evaporation", sputtering or other known reliable methods of high volume production, i.e., by a method yielding a more truly homogeneous alloy to the extent feasible. Such a laminar film may be somewhat suspect as to homogeneity, etc., and thus is "non-optimal" for most applications. However, it is considerably quicker, cheaper and more convenient to set-up on a first approximation basis; e.g., vs. a co-evaporation arrangement].

Results: generally like Ex. II, except that, rather than "islands" as described (and shown in FIG. 11, etc.), a more "filament-like", semi-discontinuous form is deposited -- this is shown in the 100,000 x TEM, FIG. 10 and, idealized, in FIG. 8; with a pair of spaced $\pm$ electrodes also shown. This "quasi-island" ("insular" or "peninsular") form seems to "agglomerate" in the described manner, forming "globs" which are more discontinuous ("quasi-pits") in the above-described manner of Ex. I, etc., and thus is assumed functionally similar. However, these filamentary peninsulae exhibit a much lower electrical resistance laterally (still quite high though) than the "islands" of Ex. I, etc. -- yet since they function similarly to write an "agglomerate-hole" it is assumed they retain much of the "thermal isolation" of the aforementioned "islands". In common with the "islands", such a filamentary configuration may also be characterized as "insular". It records like the other "insular" films forming "agglomerate holes".

Sensitivity here was maximal; better than with pure gold (Ex. I) -- e.g., approximately as "sensitive" as a tellurium absorber; often better, (e.g., about ½ the sensitivity of "Te Example" has been measured). That is, information can be satisfactorily "written" on the gold-lead tri-layer here in the power regime of 5-15 mW/10-100 n.sec. (or 100-1000 p.J.). More specifically, about 5 mW for as little as 40 n.sec. is seen to "switch reflectivity". Some samples even "switch" in about 10-15 n.sec. at 1-2 mW; others in less time at 10 mW --- all yielding satisfactory read-out (e.g., 30-40 dB S/N, etc.). This is really astonishing -- it is many times the sensitivity level that theory predicted and is really contrary to what the literature teaches one to expect. However, archivability was very poor (unacceptable for most purposes, as with pure Au and Au-Sb). And, as with Au/Sb relatively little "ejecta" is observed.

Recapitulation:

Some results of Ex.s I-XI are compared, rather loosely and qualitatively in Table II below (here assume like structure and operating/test conditions plus overcoating; note: S'y is sensitivity, A'y is archivability; "Rim" vs. "ejecta" denotes likelihood (e.g., high, low) of forming rims or ejecta; "1°", "2°", etc. denotes "best", "second best", etc. relatively; XX indicates "not acceptable").

TABLE II

|        | Au | Au/Sn | Au/Pb | Au/Sb | Au/Sn/sb | Pd/Sn |
|--------|------|-------|---------|---------|-----|------|
| S'y:   | 4°   | 5°    | 1°      | 2°      | 3°  | 4°   |
| A'y:   | 4°$_{XX}$ | 1° | 5°$_{XX}$ | 4°$_{XX}$ | 3° | 3° |
| Rim:   | Lo   | Lo    | Hi      | Hi      | Mod.| Hi   |
| ejecta | Hi   | Hi    | Lo      | Mod.    | Mod.| Lo   |

Thus, for instance, one general teaching hereof is that, in fashioning OD disks with an absorber film in "tri-layer configuration" as described, one can achieve surprisingly good sensitivity by laying-down the absorber material in island form.

Beyond that, one is taught that noble metals like gold, palladium, etc. or their alloys may be so deposited as the absorber -- e.g., to enhance archival life while securing good sensitivity.

Even more, one is taught that an island-film absorber like gold can be combined with a co-constituent like lead or antimony (e.g., in a minor %) to enhance sensitivity, and/or with a co-constituent like tin to enhance archivability and optical characteristics (e.g., increased bandwidth).

Further, one may to some degree control the hole-forming agglomeration mechanism, (e.g., to favor rim nodules on the one hand, or ejecta on the other) by combining the gold or palladium, etc. with a co-constituent (e.g., Au plus Pb or Pd plus Sn minimizes likelihood of "ejecta"; Au plus Sn and Sb to enhance S'y, A'y, bandpass and reduce ejecta).

Also, combining gold with lead, tin or antimony seems to improve its adhesion (to substrate) and help resist moisture intrusion at the absorber-spacer interface, thus enhancing archivability.

Other recording applications for such absorber films will occur to workers, such as for electron-beam or IR recording.

--Heat-opened "shutter film"; FIG. 9:

FIG. 9 schematically illustrates another application of the subject "radiation-agglomerated" island-films. Here an island-film (ab.) is understood as deposited on a suitable substrate (e.g., Au or Au alloy on glass, with clear polymer overcoat, similar to above Examples) within a frame member f. A radiant energy source LS (e.g., He-Ne laser at 6338 $\overset{o}{A}$, suitable mW) is understood as constantly (or periodically) directing an incident beam $b_i$ onto film ab.

Initially, film ab is adapted to reflect most of beam $b_i$ (e.g., as reflect beam $b_r$, toward a first detect unit $D_1$). However, when film ab (beam-impacted portion thereof) is heated to pre-set level by LS (e.g., to agglomerate-temperature -- such as by a fire, flames nearby, etc.) it will agglomerate and "clarify" (relative to $\lambda_i$ of $b_i$ -- so film ab now looks relatively transparent to $\lambda_i$). Now ab will pass beam $b_i$, as transmitted beam $b_t$ apt for detection at an associated second detect unit $D_2$.

Alternatively, source LS could be normally inactive, but upon first emitting energy, direct a portion (as beam $b_i$) to unit $D_2$ and thereby melt an aperture in film ab.

Again, alternatively, beam $b_i$ could be scanned once across film ab to "write" a pattern therein -- whereupon, with $b_i$ inactivated, a source of "backlighting illumination" could be projected at the entire "mask" so-etched (e.g., to generate a display or an optical printing plate). Workers will contemplate other like applications.

--Variations:

Workers will appreciate that such "island" (or "insular") films may comprise other metals or their alloys in certain cases (e.g., other binary alloys of Au or Pd, ternary alloys, etc. or other metals such as $P_t$, Cu, Ag, $R_h$). In many instances, the absorber film will be advantageously combined in an anti-reflection or like optical background array.

Such island films may, in certain instances, be otherwise deposited, e.g., by other vapor-deposition techniques (vapor-deposition is very practical where, as in Ex. I, etc., it may also be used to deposit other related layers such as the reflector, spacer, etc.). Vapor co-deposition will usually be preferred for "alloys". Other methods may be feasible for depositing the absorber, such as sputtering. In any event, it will usually be preferred to monitor the film during deposition to closely control the deposited island configuration.

--Conclusion:

It will be understood that the preferred embodiments described herein are only exemplary, and that the invention is capable of many modifications and variations in construction, arrangement and use without departing from the spirit of the invention.

Further modifications of the invention are also possible. For example, the means and methods disclosed herein are also applicable to other ultra-thin films adapted to be optically-switched when suitably irradiated.

The above examples of possible variations of the present invention are merely illustrative. Accordingly, the present invention is to be considered as including all possible modifications and variations coming within the scope of the invention as defined by the appended claims.

What is claimed is:

1.      In an energy detect system adapted to detect a test-level of energy, the combination comprising:

an optical detect medium;

source means for providing monitor radiation of a prescribed wavelength,

means for directing said radiation as a beam along a detect axis to present a prescribed energy level at said medium and associated detect means disposed along said axis with the medium interposed in beam intersecting relation with said source means;

the medium comprising at least one ultra-thin, discontinuous layer of absorber material deposited in island form so as to be "agglomerated" upon application of said beam at said test level of energy whereby to alter an optical characteristic thereof for detection by said detect means; said island-film presenting well separated "islands" of the absorber material having an average width very considerably smaller than the width of said monitor beam.

2.      The invention in accordance with claim 1, wherein the absorber material comprises at least one noble metal.

3.    In a heat detect system, the combination comprising: source means for providing a monitor radiation beam having a predetermined wavelength and energy level along a prescribed axis; detect means for receiving said beam and responsively emitting an output; and an optical medium interposed in beam-intercepting relation between said source means and detect means, said medium comprising at least one discontinuous layer of absorber material deposited in island form so as to normally either assume a STOP state, attenuating said beam and preventing said output emission at said detect means or a GO state passing the beam to allow the output, in a First condition; while also being adapted to "agglomerate" upon application of a prescribed test-level of heat whereby to detectably alter an optical characteristic thereof and so assume a Second condition reversing the STOP or GO state of said First condition, said layers presenting well-segmented "islands" of one or several absorber materials, the islands having an average width considerably smaller than the width of said beam; said beam energy level being insufficient to cover such agglomeration.

4.      An optical medium for use in an optical heat detect system providing a focused monitor-beam of radiation on said medium, at prescribed wavelength, said medium comprising at least one layer of absorber material deposited in discontinuous island form so as to be "agglomerated" upon application of a test level of heat energy whereby to detectably alter an optical characteristic so as to facilitate readout of the beam by prescribed associated optical detect means, the island-layers so formed presenting well-segmented "islands" of absorber material having an average width considerably smaller than the width of said beam.

046-285-W/O

0096503

5. The invention in accordance with claim 1, 2, 3 or 4, wherein said radiation beam is from a laser source; wherein detect means is disposed to detect the level of beam-light reflected by said medium; and wherein said medium comprises a plurality of layers including a reflective layer, a clear polymer spacer layer overlying said reflective layer, and an absorber layer, or layers, in island form overlying said spacer layer, the thicknesses and optical reflectance characteristic of said layers and the optically detectable reflectance changes of said absorber layer(s) being chosen, in conjunction with the test-level of detected energy and wavelength of the beam such that, the detected beam intensity will vary in accordance with whether or not the test-level of energy has occurred, the intensity of said beam additionally being chosen so as to not significantly affect medium reflectance.

6. The invention in accordance with claim 5, wherein said absorber island layers are deposited by evaporation from a melt in a vacuum.

7. The invention in accordance with claim 6, wherein the overall thickness of said absorber island layers is the order of a few hundred Angstroms or less.

8. The invention in accordance with claim 7, wherein said polymer spacer layer comprises polytetrafluoroethylene.

9.      The invention in accordance with claim 5, wherein the medium is fabricated by providing an anti-reflection base on which the island layers are deposited, whereby a prescribed minimal reflectance is exhibited by unrecorded portions of the medium.

10.     The invention as recited in claim 9, wherein said island layers are deposited only until yielding a prescribed initial minimal reflectance value.

11.     The invention as recited in claim 10, wherein the island layers are so vapor deposited while monitoring reflectance thereof.

12.     The invention as recited in claims 1, 2, 3 4, or 5, wherein said island layers are so deposited and so adapted to conserve test energy incident on the medium whereby to facilitate low-energy/low-temperature operation, without need to heat the absorber material to its bulk melting temperature.

13.     The invention as recited in claim 12, wherein the average size and spacing of the islands so rendered is selected and adapted to facilitate such "agglomeration" during such test heating whereby to significantly shift reflectance.

14.     The invention as recited in claim 12, wherein the island layers are so formed as to yield such changes upon such test heating, yet without necessarily involving any significant expulsion of absorber material from the medium beam-intercepting site.

15.      A method of fabricating a medium for use in an optical heat-sensing system, the system providing a monitor laser beam of predetermined wavelength and energy, this beam to be focused upon said medium while detect means is also provided in reflected-beam relation with the medium, said method including the steps of:

providing a reflective medium support means having thereon a prescribed clear polymer spacer layer; and

depositing the medium as one or more absorber layers in island-form over said spacer layer;

the thicknesses and optical characteristics of said layers being chosen so that, at said write-wavelength, an anti-reflection condition will prevail on "virgin portions" of said medium not subjected to a test-level of heat,

the thicknesses and optical characteristics of said layers being further chosen so that said test level of heat energy is just sufficient to detectably disturb the anti-reflection condition thereat and so alter its optical characteristics as to facilitate prescribed optical read-out.

16.     The invention in accordance with claim 15, wherein said absorber layers are deposited by vapor deposition only until a prescribed low-reflectance level is first detected.

17.     A method of preparing an improved radiation-sensing record blank wherein an information layer is disposed on substrate means and is adapted to respond to, and sense, a prescribed test level of energy while being monitored by a laser beam of prescribed energy and wavelength, this method including the steps of:

depositing an "absorber material" to a prescribed relatively miniscule depth on the substrate means such as to constitute a discontinuous record-film exhibiting. an array of separated "islands" and having a prescribed virginal-reflectance so as to appear "optically-continuous" to said laser beam; whereby if such a test level of energy is received it will induce a prescribed "agglomeration" of the absorber islands to make the film appear more discontinuous optically and optically-apertured there, and to thereby shift the detected reflectance of the blank; the absorber material being selected and so vapor-deposited, in conjunction with the surrounding optical/thermal environment, as to so "agglomerate".

18. The method as recited in claim 17, wherein the substrate means comprises an optical anti-reflective substrate and wherein said absorber material is vapor-deposited thereon only until a prescribed low-level virginal reflectance first appears.

19. The method as recited in claim 18, wherein the absorber material comprises a major portion of a prescribed "absorber-metal" evaporo-deposited only until minimal reflectance is first exhibited.

20. The method as recited in claim 18, wherein said metal is combined with at least one other metal adapted to enhance adhesion.

046-285-W/O

0096503

21.    A temperature detecting system comprising:
radiation source means adapted to project a radiation beam
of prescribed wavelength and energy along a
prescribed detect axis;
beam detect means disposed along this axis spaced from said
source means and adapted to provide a prescribed
ON-output upon reception of said beam energy; and
temperature-shutter means disposed along said axis
intermediate said source and detect means and
presenting temperature sensitive optical shield
means adapted to block or at least attenuate said
beam sufficient to prevent said output from the
detect means at temperatures below a prescribed
test-level;
said shield means comprising an absorber film in discontinuous
island form and normally relatively blocking or
attenuating of said beam as aforementioned, said
film being adapted however to be so "agglomerated"
when subject to minimum test-heat corresponding to
said test-level temperature whereupon the film loses
sufficient of its attenuation property to "pass"
the beam and allow said output from the detect means.

22.    The invention in accordance with claim 21, wherein
said absorber island film is deposited by evaporation from a
melt in a vacuum.

23.    The invention in accordance with claim 21, wherein
the overall thickness of said absorber island film is the
order of a few hundred Angstroms or less.

# FIG.1.

# FIG.2.

# FIG.3.

# FIG.4.

# FIG.5.

215
ST
214
213
212-S
212

Z-AR

# FIG.6.

(e)
15p
15v
gl
gl
15v

## FIG.7.

REFLECTANCE OF TRILAYERS.

INDEX
OF
REFR'N

$R_y{}'$

A

B

C

$\lambda \, (\overset{\circ}{A})$

4000

5000

6000

He-Ne

Ga As

FORMOTTING

## FIG.8.

−

+

# FIG.9.

# FIG.10.

FIG.11.

FIG.12.

FIG.13.

5/5

0096503